Europäisches Patentamt

**European Patent Office**

Office européen des brevets

(19)

(11) Publication number: **0 141 455**
**B1**

(12) # EUROPEAN PATENT SPECIFICATION

(45) Date of publication of patent specification: **25.05.88**

(51) Int. Cl.⁴: **B 62 J 6/00**

(21) Application number: **84201387.2**

(22) Date of filing: **27.09.84**

(54) Lamp holder.

(30) Priority: **27.09.83 NL 8303307**

(43) Date of publication of application:
**15.05.85 Bulletin 85/20**

(45) Publication of the grant of the patent:
**25.05.88 Bulletin 88/21**

(84) Designated Contracting States:
**AT BE CH DE FR GB IT LI LU NL SE**

(56) References cited:
**DE-A-2 519 837**
**DE-A-2 526 490**
**DE-A-2 821 853**
**US-A-2 278 614**
**US-A-4 117 457**
**US-A-4 290 048**
**US-A-4 323 879**

(73) Proprietor: **EKOLIGHT P.v.b.A.**
**Steenweg op Elewijt 114-116**
**B-1840 Eppegem-Zemst (BE)**

(72) Inventor: **Kockaert, Frans**
**114 Elewijtsesteenweg**
**B-1840 Eppegem-Zemst (BE)**
Inventor: **Kockaert, Willy**
**Stuyvenbergvaart 134**
**B-2800 Mechelen (BE)**

(74) Representative: **Hoorweg, Petrus Nicolaas et al**
**OCTROOIBUREAU ARNOLD & SIEDSMA**
**Sweelinckplein 1**
**NL-2517 GK The Hague (NL)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

The invention relates to a lamp holder, particularly for use on a vehicle driven by muscular force, for example a bicycle, said holder mainly comprising a housing accommodating a light source carried by a reflector, a group of batteries and a circuit arrangement formed by a plurality of components.

For a lamp holder of the kind set forth several proposals have been made in order to have light on a bicycle even when it is standing still. For this purpose the lamp holder is equipped with batteries that can be or cannot be recharged, which has, apart from the above-mentioned effect, the advantage that the conventional dynamo may be dispensed with, which contributes to the comfort of the bicycle, since the otherwise required driving force for the dynamo need not be produced. Moreover, in bad weather there will always be sufficient light.

The embodiments hitherto proposed have the disadvantage that the lamp holder is relatively heavy, bulky and expensive in manufacture so that these known types of lamps appeared not to be marketable.

The invention has for its object to provide a lamp holder which can be manufactured in a simple manner and hence at low costs.

The lamp holder embodying the invention is distinguished in that the components of the circuitry are fastened to a carrier formed by a printed plate being in directly conductive contact with the light source and the group of batteries.

Therefore, mounting of the lamp holder is limited to the disposition of mainly three parts i.e. the reflector, the circuitry carrier and the group of batteries. Owing to the direct contact between the printed plate and the battery and the light source respectively the resultant construction occupies particularly little space and has a low weight.

Mounting can be further simplified in that in accordance with the invention the housing is formed by at least two dishes fitting to one another along a dividing plane and in that the carrier is releasably arranged in the housing in the form of a partition transverse of said dividing plane. Moreover, the moisture tightness is considerably improved by using the print, in addition, as an additional protective part for the group of batteries. Preferably the circuitry of the carrier comprises a rectifier connected in series with the light source and connectable through a circuit element with the group of batteries. In this way the lamp holder embodying the invention can be used in conjuction with a conventional dynamo so that when the batteries are exhausted, they can be recharged.

In a further embodiment the circuitry of the carrier comprises a contact box for an external direct-voltage source. Thus the group of batteries can be connected to the mains, when the bicycle is not used, through an external rectifier for recharging the batteries.

In order to avoid overcharging of the batteries a resistor and a diode connected in series with the former is arranged, in accordance with the invention, parallel to the group of batteries so that redundant energy is neutralized and an indication of the full charge of the batteries if obtained.

The invention will be described more fully with reference to a few embodiments.

The drawing shows in:

Fig. 1 a vertical sectional view of a lamp holder embodying the invention,

Fig. 2 a plan view of the lamp holder of fig. 1, the top hood being removed,

Fig. 3 a front view of a print used in the lamp holder of fig. 1,

Fig. 4 a circuitry associated with the print,

Fig. 5 an elevational view of the print of fig. 3 with the components of the circuitry of fig. 4 arranged thereon,

Figs. 6 and 7 a front view and a circuit diagram respectively of an alternative print and the associated circuitry.

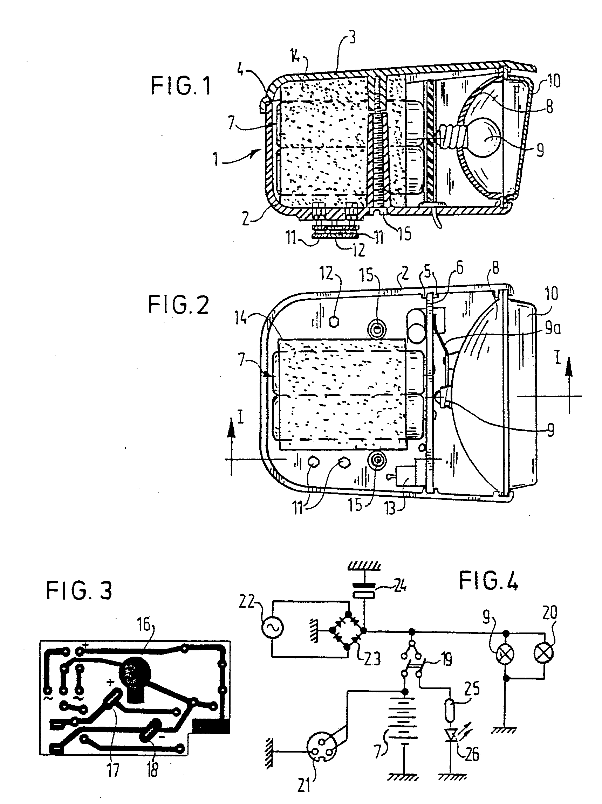

The lamp holder shown in figs. 1 and 2 mainly comprises a housing 1, which may be made from any appropriate material, for example, synthetic resin. The housing comprises a bottom dish 2 and a cover dish 3 which can be fastened to one another in a dividing plane 4.

The bottom dish 2 is provided on the inner side with stop ridges 5, between which a print plate 6 can be arranged to form a partition transverse of the dividing plane 4.

The print plate 6 divides the space in the housing 1 into two compartments i.e. a left-hand compartment for a group of batteries 7 (see fig. 2) and a right-hand compartment for a reflector 8 with a light source 9 of any kind screwed into the reflector. On the front side the reflector 8 can be closed by a conventional closing cap 10 of transparent material.

The bottom dish 2 is provided on the underside with connecting terminals 11 for the dynamo and 12 for the tail tight. There is furthermore provided a connection 13 for an external feed source formed by a contact box.

The lamp holder described above is mounted as follows:

After assembling the batteries in a group 7, which may be done in any suitable manner, for example, by arranging them in a suitable envelope 14 of any suitable material, after inserting the print plate 9 from above between the ridges 5 of the lower dish half 2 and after disposing the reflector 8 and the cover 10 from above, the top dish of the housing can be clamped to the lower part by means of two parker screws 15, which are inserted from below into the cover dish 3. It is only necessary to establish before the connection between the print plate 6 and the connecting terminals 11 and 12. Further connections are redundant thanks to the direct contact between the contact foot of the light source 9 and the conductive part on the print plate 6 as well as to the contact points of the batteries of the group 7 on the other side of the print plate 6. From the figures and from the foregoing description it is obvious that mounting is extremely simple, whilst the bulk of the lamp can be minimized.

The print plate 6 may be designed in any desired manner; it depends *inter alia* on the number of batteries of the group 7. The batteries are arranged in series in the group 7 and are intercoupled in a conventional manner at the ends remote from the print plate. This coupling is not shown in the figures. Moreover, the print plate configuration depends on the desired circuitry and the possibilities of use.

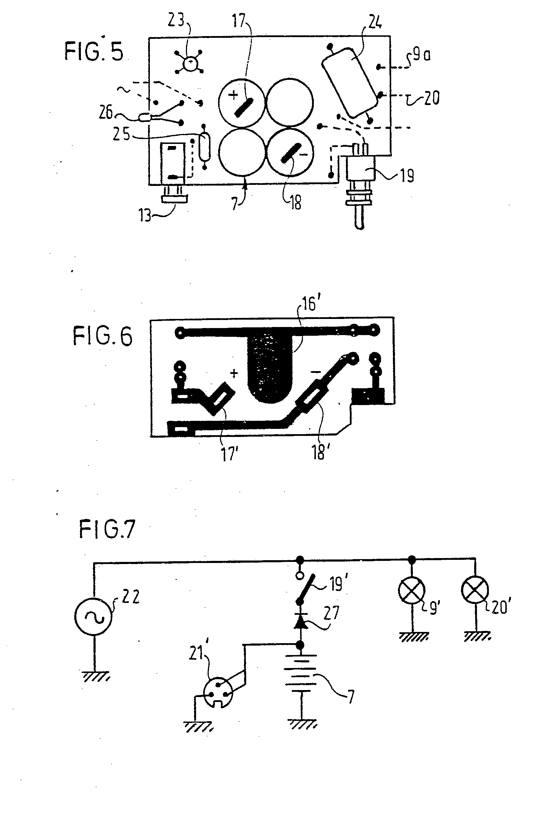

The side shown in figs. 3 and 6 is provided with the "wiring" of the print plate and is located on the reflector side in the lamp housing. The resilient connecting plate 16 serves as the minus pole for the contact foot of the light source 9. A spring tongue 9a fastened to the rear side of the reflector serves as a plus pole for the light source 9, said tongue being in direct electric contact with the plus line on the print plate 6. The contact 17 and 18 are the plus and minus connections for the batteries, which are in contact with the contact strips on the rear side of the print plate (see fig. 5).

To said rear side of the print plate can be soldered the desired components before the lamp is assembled. Therefore, the entire circuitry is prefabricated as a single unit and is mounted as such in the lamp.

The print plate and the components shown in figs. 3 and 5 are schematically illustrated in fig. 4.

Reference numeral 7 designates the group of batteries, which can be connected through a switch 19 in a circuit with the light source 9 and a tail light 20 respectively (see fig. 5). The group of batteries 7 is connected by the switch 19 with the contact box 13 (Figs. 2 and 5), for connection to an external direct-voltage source 21. Thus the batteries of the group 7 can be charged.

A second voltage source for the light source 9 may be the dynamo 22 of the bicycle, which is coupled through a rectifying bridge 23 with the feed lines to the light sources 9, 20. Between mass and bridge 23 is arranged a capacitor 24.

Finally the switch 19 having a double structure establishes a connection to a resistor 25 and a diode 26, which ensure the destruction of the redundant energy furnished by the dynamo 22 when the group of batteries 7 is charged. The ignition of the diode 26 is an indication to the user that the batteries are charged and that the dynamo 22 can be switched off.

From the diagram described above it is apparent that the user can use the lamp holder in two situations i.e. one position of the switch 19 in which the light sources 9, 20 are fed through the group of batteries 7 and a position of the switch 19 in which the dynamo 22 is switched on.

When not in use the lamp holder can be connected to the mains through the contact box 13.

Figs. 6 and 7 show an alternative embodiment for, for example three batteries disposed side by side and connected to the contacts 17' and 18'. The plate 16' serves to contact the light source 9.

In this embodiment the group of batteries 7 can be switched off and the dynamo 22 can be switched on. Through the diode 27 after the switch 19' the risk of the battery cell becoming defective is excluded.

The invention is not limited to the embodiments described above. The lamp holder may also be used with the conventional batteries, which can also be replaced by the user in a simple manner by lifting the cap from the lamp holder.

In both cases it is also possible to read the voltage value of the battery cell.

## Claims

1. A lamp holder, particularly for use on a vehicle driven by muscular force, for example a bicycle, said holder mainly comprising a housing (1) accommodating a light source (9) carried by a reflector (8), a group of batteries (7) and a circuitry having a plurality of components characterized in that the components are fastened to a carrier formed by a spring plate (6) being in directly conducting contact with the light source (9) and the group of batteries (7).

2. A lamp holder as claimed in claim 1, characterized in that the housing (1) comprises at least two dishes (2, 3), fitting to one another along a dividing plane (4) and in that said carrier (6) is releasably arranged in the housing as a partition transverse of said dividing plane.

3. A lamp holder as claimed in claims 1 and 2 comprising at least one rechargeable battery (7) characterized in that the circuitry provided on the carrier (6) comprises a rectifier (23) connected in series with the light source (9) and connectable through a switching element (19) with the group of batteries.

4. A lamp holder as claimed in claims 1 to 3 characterized in that the circuitry on the carrier is connected to a contact box (13) for an external direct-voltage source (21).

5. A lamp holder as claimed in claims 1 to 4, characterized in that the circuitry on the carrier comprises, in parallel to the group of batteries (7), a resistor (25) and a diode (26) connected in series to the former.

## Patentansprüche

1. Lampengehäuse, insbesondere für den Gebrauch bei einem muskelbetriebenen Fahrzeug, z.B. einem Fahrrad, mit einem Gehäuse, zur Aufnahme einer von einem Reflektor (8) getragenen Lichtquelle (9), einer Gruppe von Batterien (7) und einem Schaltungsaufbau aus einer Anzahl von Bauteilen, dadurch gekennzeichnet, daß die Bauteile an einem Träger befestigt sind, der aus einer gedruckten Platte (6) gebildet ist, die in direktem leitendem Kontakt mit der Lichtquelle (9) und der Gruppe von Batterien (7) steht.

2. Lampengehäuse nach Anspruch 1, dadurch gekennzeichnet, daß das Gehäuse (1) zumindest zwei Schalen (2, 3) aufweist, die entlang einer Trennebene (4) aneinander passen, und daß der Träger (6) lösbar in dem Gehäuse als Trennwand, quer zu der Trennebene angeordnet ist.

3. Lampengehäuse nach Anspruch 1 oder 2 mit zumindest einer aufladbaren Batterie (7), dadurch gekennzeichnet, daß der Schaltungsaufbau auf dem Träger (6) einen Gleichrichter (23) aufweist, der in Reihe mit der Lichtquelle (9) geschaltet ist und über ein Schaltelement (19) mit der Gruppe von Batterien verbindbar ist.

4. Lampengäuse nach Anspruch 1, 2 oder 3, dadurch gekennzeichnet, daß der Schaltungsaufbau auf dem Träger mit einer Anschlußbuchse (13) für eine externe Gleichspannungsquelle (21) verbunden ist.

5. Lampengehäuse nach einem der Ansprüche 1 bis 4, dadurch gekennzeichnet, daß der Schaltungsaufbau auf dem Träger, parallel zu der Gruppe von Batterien (7) einen Widerstand (25) und eine dazu in Reihe geschaltete Diode (26) aufweist.

**Revendications**

1. Boîtier de lampe, destiné en particulier à être utilisé sur un véhicule mu par une force musculaire, par exemple une bicyclette, le boîtier comprenant essentiellement un carter (1) logeant une source lumineuse (9) portée par un réflecteur (8), un groupe d'accumulateurs ou de piles (7) et un circuit ayant plusieurs composants, caractérisé en ce que les composants sont fixés à un support formé par une plaque (6) de circuit imprimé qui est directement en contact conducteur avec la source lumineuse (9) et le groupe d'accumulateurs ou de piles (7).

2. Boîtier de lampe selon la revendication 1, caractérisé en ce que le boîtier (1) comporte au moins deux cuvettes (2, 3), ajustées l'une sur l'autre le long d'un plan de séparation (4), et en ce que le support (6) est disposé de façon amovible dans le boîtier sous forme d'une cloison transversale au plan de séparation.

3. Boîtier de lampe selon l'une des revendications 1 et 2, comprenant au moins un accumulateur (7), caractérisé en ce que le circuit formé sur le support (6) comprend un redresseur (23) monté en série avec la source lumineuse (9) et destiné à être connecté par un élément de commutation (19) au groupe d'accumulateurs ou de piles.

4. Boîtier de lampe selon l'une quelconque des revendications 1 à 3, caractérisé en ce que le circuit porté par le support est connecté à un boîtier (13) de contact destiné à une source externe (21) d'une tension continue.

5. Boîtier de lampe selon l'une quelconque des revendications 1 à 4, caractérisé en ce que le circuit porté par le support comporte, en parallèle par rapport au groupe d'accumulateurs ou de piles (7), une résistance (25) et une diode (26) montées en série avec le groupe.

FIG.1

FIG.2

FIG. 3

FIG.4

**FIG. 5**

**FIG. 6**

**FIG.7**